# EUROPÄISCHE PATENTSCHRIFT

(11) **EP 0 515 424 B1**
(45) Veröffentlichungstag und Bekanntmachung des Hinweises auf die Patenterteilung: **18.05.1994**
(21) Anmeldenummer: 91903388.6
(22) Anmeldetag: 15.02.1991
(51) Int. Cl.: H03M 7/22, H03M 1/36

(54) **CODIERSCHALTUNG**
CODING CIRCUIT
CIRCUIT DE CODAGE

(30) Priorität: 15.02.1990 DE 4004735
(43) Veröffentlichungstag der Anmeldung: 02.12.1992
(73) Patentinhaber: SIEMENS AKTIENGESELLSCHAFT, 80333 München (DE)
(72) Erfinder: ZOJER, Bernhard, A-9500 Villach (AT)
(86) Internationale Anmeldenummer: DE9100120
(87) Internationale Veröffentlichungsnummer: WO9112669

(56) Entgegenhaltungen:
- EP-A- 0 120 424
- US-A- 3 959 791
- US-A- 4 897 657

## Beschreibung

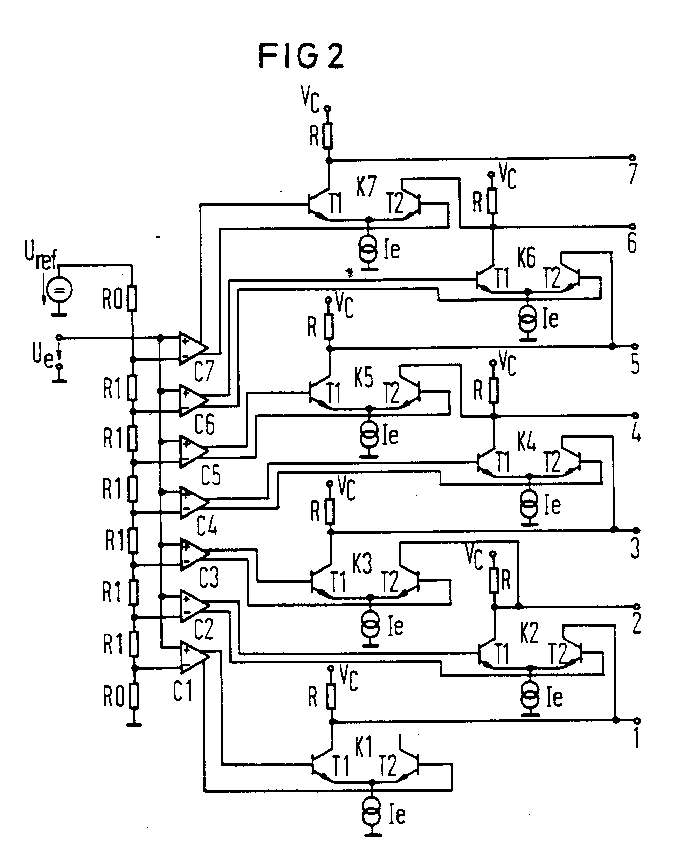

Es sind Codierschaltungen bekannt, bei denen zwei aufeinanderfolgende Komparatorstufen derart in einer Ausgangsstufe zusammengeschaltet sind, daß ein ein High-Signal liefernder Komparator ein Low-Signal in der ihm zugeordneten Ausgangsstufe bewirkt und daß ein ein Low-Signal liefernder Komparator in der nächst tieferliegenden Ausgangsstufe ein Low-Signal bewirkt, so daß nur die Ausgangsstufe im Bereich des Vorzeichenwechsels der Komparatoren ein High-Signal liefert. Außerdem sind solche Schaltungen mit umgekehrter Logik bekannt. Diese Ausgangsstufe kann hierbei, wie in Siemens Forschungs- und Entwicklungsberichte, Band 15 (1986) Nr. 2 in dem Artikel "An 8-bit/120 MHz Full-Nyquist Analog-to-Digital Converter" von Zojer und Petschacher, insbesondere auf Seite 69 in Figur 2 gezeigt, auch Teil eines Komparators sein.

Solche Codierschaltungen haben bei nicht eindeutigen Logikeingangspegeln im Bereich des Vorzeichenwechsels Schwierigkeiten, eindeutige Ausgangspegel zu liefern. Dies führt insbesondere bei hoher Abtastrate zu einer nicht vernachlässigbaren Fehlerrate aufgrund metastabiler Zustände. Das Problem metastabiler Zustände ist unter anderem in dem Artikel "A 6-Bit/200-MHz Full Nyquist A/D Converter" von Zojer, Petschacher und Luschnig, IEEE Journal of Solid-State Circuits. Vol. cs-20, No. 3, June 1985, Seiten 780 bis 786 beschrieben.

Ein weiteres Problem beim Umsetzen eines von einer Komparatorstufe gelieferten sogenannten Thermometercodes bzw. X aus N-Codes in einen sogenannten 1 aus N-Code ist darin zu sehen, daß der Thermometercode fehlerhaft sein kann, also einzelne Bit-Stellen des Thermometercodes ein falsches Potential aufweisen. Dieses Problem wird üblicherweise durch Verknüpfen von mehr als zwei Komparator-Ausgangssignalen in einer Codier-Ausgangsstufe eingeschränkt. Eine solche Anordnung ist beispielsweise in der US-A-4 897 657 beschrieben.

Die beschriebenen Codierschaltungen sind üblicherweise in Analog-Digital-Umsetzern nach dem Parallelverfahren eingesetzt. Solche sogenannten Flash-Wandler sind unter anderem in Tietze/ Schenk, Halbleiterschaltungstechnik, 5. Auflage 1980, Seiten 653ff, insbesondere Abbildung 24.26 mit zugehöriger Beschreibung, beschrieben. Die dort gezeigten Komparatoren der Analog-Signaleingangsstufe stellen jedoch ein unsymmetrisches Ausgangssignal bereit. Aus der EP-A2-0 282 147 (US-A-4 712 087) ist eine entsprechende Analog-Digital-Wandlerschaltung mit einer aufwendigen Reparaturschaltung bekannt, die aus einem von Komparatoren mit unsymmetrischen Ausgangssignal bereitgestellten fehlerhaften Thermometercode einen fehlerfreien Thermometercode bildet.

FIG 2 zeigt eine Schaltungsanordnungnach dem Stande der Technik, bei der die Ausgangsspannung einer Referenzspannungsquelle U_{ref} über die Serienschaltung aus einem Widerstand Ro, sechs Widerständen R1 und einem weiteren Widerstand Ro gegen Bezugspotential geschaltet ist, wobei vorzugsweise die Widerstände Ro halb so groß dimensioniert sind wie die Widerstände R1. Außerdem zeigt FIG 2 sieben Komparatorschaltungen C1, C2, C3, C4, C5, C6 und C7, deren nichtinvertierende Eingänge zusammengeschaltet und mit einem Analog-Eingangssignal Uₑ beaufschlagt sind und deren invertierender Eingang jeweils an einen anderen Verbindungsknoten zwischen zwei Widerständen Ro und R1 bzw. R1 und R1 geschaltet ist. Die gezeigten Komparatorschaltungen weisen symmetrische Ausgänge auf. Außerdem ist eine Codierschaltung, bestehend aus sieben Teilschaltungen K1, K2, K3, K4, K5, K6 und K7 dargestellt. Jede Teilschaltung dieser Codierschaltung besteht jeweils aus einem ersten Transistor T1 und einem zweiten Transistor T2, deren Emitter zusammengeschaltet und jeweils über eine Stromquelle Ie gegen Bezugspotential geschaltet sind. Der Kollektoranschluß jedes Transistors T1 ist jeweils über einen Widerstand R an ein Versorgungspotential V_{C} geschaltet und bildet jeweils den Signalausgang 1, 2, 3, 4, 5, 6 oder 7 dieser Teilschaltung. Die Basisanschlüsse der Transistoren T1 und T2 jeder Teilschaltung K1, K2, K3, K4,... sind jeweils mit dem symmetrischen Signalausgang einer der Komparatorschaltungen C1, C2, C3,... verbunden, so daß jede Teilschaltung K1, K2,... der Codierschaltung jeweils das Ausgangssignal eines speziellen Komparators C1, C2,... auswertet. Der Kollektoranschluß des Transistors T2 jeder Teilschaltung ist jeweils mit dem Signalausgang der Teilschaltung verbunden, die von dem Komparator C1, C2,... mit der nächst niedrigeren Schaltschwelle angesteuert wird. Der Kollektoranschluß des Transistors T2 der Teilschaltung K1 wird, eventuell über einen nicht dargestellten Widerstand mit Versorgungspotential beaufschlagt. Bei den dargestellten Teilschaltungen K1, K2,... bedeutet eine logische 1 am Eingang, daß der Transistor T1 mit Low-Pegel und der Transistor T2 mit High-Pegel angesteuert ist.

Aufgabe der Erfindung ist das Bereitstellen einer Codiersschaltung, die beim Auftreten eines fehlerhaften Thermometercodes oder beim Auftreten metastabiler Zustände eine geringere Fehlerrate aufweist und gegenüber bekannten Schaltungen keinen zusätzlichen Stromverbrauch hat.

Diese Aufgabe wird gelöst durch eine Codierschaltung nach dem Patentanspruch 1.

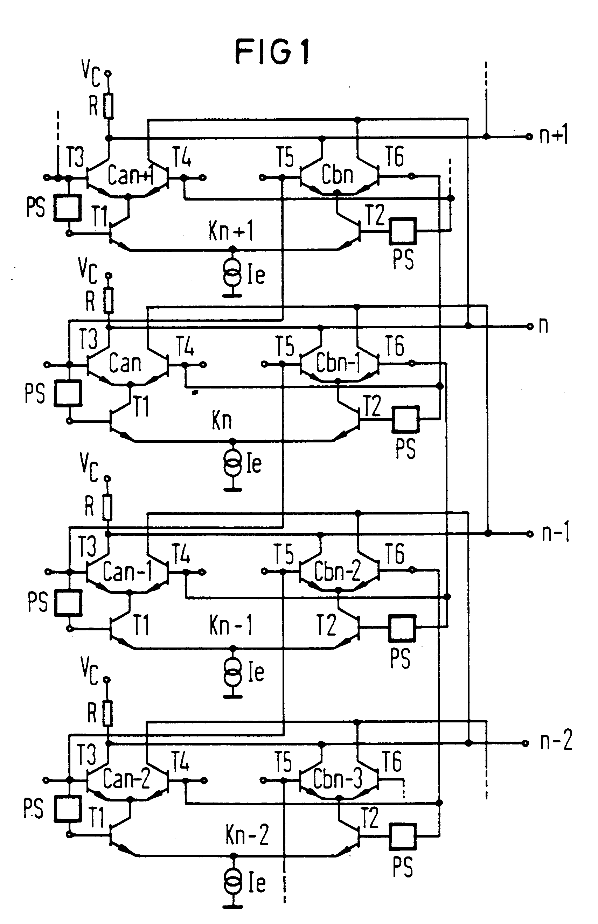

Nachfolgend wird die Erfindung anhand der Figur 1 näher erläutert.

Die Figur 1 zeigt als Ausführungsbeispiel eine erfindungsgemäße Codierschaltung für Systeme mit symmetrischem Eingang bestehend aus einer Vielzahl von Differenzverstärkerschaltungen ..., Kn-1, Kn, Kn+1, ... . In diesem Ausführungsbeispiel besteht jede Differenzverstärkerschaltung aus einem ersten Transistor T1 und einem zweiten Transistor T2, deren Emitter gemeinsam über eine Stromquelle Ie an Bezugspotential geschaltet sind. In den Kollektorkreisen dieser Differenzverstärker-Transistoren T1 und T2 sind Codiererstufen in Form von emittergekoppelten Transistorpaaren geschaltet. An den Kollektoranschluß des Transistors T1 des Differenzverstärkers Kn ist der Emitteranschluß eines Transistors T3 und der Emitteranschluß eines Transistors T4 angeschlossen , die gemeinsam den Teil Can einer Codiererstufe bilden. Der Kollektoranschluß des Transistors T3 ist über einen Widerstand R an das Versorgungspotential V_{C} geschaltet wird. Der Kollektoranschluß des Transistors T2 des Differenzverstärkers Kn ist mit dem Emitteranschluß eines Transistors T5 und mit dem Emitteranschluß eines Transistors T6 verbunden, die den Teil einer Codiererstufe Cbn-l bilden. Der Kollektoranschluß des Transistors T5 ist mit dem Kollektoranschluß des Transistors T3 dieser Stufe sowie mit den Kollektoranschlüssen der Transistoren T6 und T4 der übergeordneten Stufe, die an den Differenzverstärker Kn+1 angeschlossen ist, geschaltet und bilden den Signalausgang n der Teilschaltung aus Differenzverstärker Kn und Codierstufen Can und Cbn-1. Von den Transistoren T4 und T6, die dem Differenzverstärker Kn zugeordnet sind, sind die Kollektoranschlüsse an die Kollektoranschlüsse der Transistoren T5 und T3 der nächst unteren Stufe, die dem Differenzverstärker Kn-1 zugeordnet ist, angeschlossen und bilden den Signalausgang n-1 der Teilschaltung aus Differenzverstärker Kn-1 und Codierstufen Can-1 und Cbn-2. Die übrigen angrenzenden Stufen sind entsprechend geschaltet.

Die Basisanschlüsse der Transistoren T3 und T4 bilden jeweils den Signaleingang einer Teilschaltung der Codierschaltung, wobei der Basisanschluß des Transistors T3 der Codierstufe Can mit dem Basisanschluß des Transistors T5 der Codierstufe Cbn zusammengeschaltet ist und außerdem über eine Pegelschiebeschaltung PS an den Basisanschluß des Transistors T1 des Differenzverstärkers Kn geschaltet ist und wobei der Basisanschluß des Transistors T4 der Codierstufe Can mit dem Basisanschluß des Transistors T6 der Codierstufe Cbn verbunden ist und über eine weitere Pegelschieberschaltung PS mit dem Basisanschluß des Transistors T2 der Differenzverstärkerstufe Kn verbunden ist. In gleicher Weise ist der Basisanschluß des Transistors T3 der Codierstufe Can-1 mit dem Basisanschluß des Transistors T5 der Codierstufe Cbn-1 zusammengeschaltet und außerdem über einen Pegelschieber PS an den Basisanschluß des Transistors T1 des Differenzverstärkers Kn-1 geschaltet und außerdem ist der Basisanschluß des Transistors T4 der Codierstufe Can-1 mit dem Basisanschluß des Transistors T6 der Codierstufe Cbn-1 zusammengeschaltet und über einen Pegelschieber PS an den Basisanschluß des Transistors T2 des Differenzverstärkers Kn-l angeschlossen. Die Basisanschlüsse der übrigen Stufen sind entsprechend geschaltet.

Erfindungsgemäße Codiererschaltungen dienen unteranderem als Ausgansstufe einer Vielzahl von Komparatorschaltungen in einem Analog-Digital-Umsetzer und codieren einen von diesen Komparatorschaltungen bereitgestellten "Thermometercode" in einen "1 aus N-Code" um. Die einzelnen Eingangssignale einer erfindungsgemäßen Codierschaltung weisen im normalen Betriebsfall folglich unterhalb einer bestimmten Teilschaltung der Codierschaltung, beispielsweise unterhalb der Teilschaltung, gebildet aus dem Differenzverstärker Kn und den Codierstufen Can und Cbn-1, eine bestimmte Polarität auf und oberhalb dieser Teilschaltung die hierzu entgegensetzte Polarität. Hierbei ist zu beachten, daß die Codierstufe Cbn der Teilschaltung Can+1, Cbn und Kn+1 mit dem gleichen Signal angesteuert wird wie die Codierstufe Can und der Differenzverstärker Kn. Das Eingangssignal des Differenzverstärkers Kn unterscheidet sich hierbei jedoch um einen festen Spannungswert vom Eingangssignal der Codierstufen Can und Cbn, was durch eine Pegelschieberschaltung PS erreichbar ist.

Auch die übrigen Differenzverstärker ...,Kn-2, Kn-1, Kn, Kn+1,... sind entsprechend ihrer Indizierung mit dem gleichen Eingangssignal angesteuert wie die Codierstufen ...,Can-2, Can-1, Can, Can+1... und die Codierstufen ...,Cbn-3, Cbn-2, Cbn-1, Cbn,..., wobei zwischen dem gleichen symmetrischen Eingangssignal, das eine Differenzverstärkerschaltung, z. B. Kn-1, und entsprechend indizierte Codierstufen, z. B. Can-1 und Cbn-1, ansteuert, jeweils eine feste Gleichspannungsdifferenz besteht. Im einzelnen liegt also am Basisanschluß des Transistors T3 der Codierstufe Can der gleiche Signalpegel wie am Basisanschluß des Transistors T5 der Codierstufe Cbn und am Basisanschluß des Transistors T1 des Differenzverstärkers Kn liegt das gleiche Signal, verschoben um eine additive Gleichspannungskomponente, an. Ebenso liegt am Basisanschluß des Transistors T4 der Codierstufe Can derselbe Signalpegel wie am Basisanschluß des Transistors T4 der Codierstufe Cbn und außerdem liegt dieses Signal, verschoben um die oben erwähnte additive Gleichspannungskomponente auch am Basisanschluß des Transistors T2 des Differenzverstärkers Kn an.

Der Strom durch einen Widerstand R jeder Teilschaltung der Codierschaltung, der die Polarität des Ausgangssignales dieser Teilschaltung festlegt, wird somit sowohl durch das Eingangssignal des Differenzverstärkers dieser Teilschaltung selbst als auch durch die Eingangssignale der Differenzverstärker der beiden benachbarten Teilschaltungen festgelegt.

Tritt an den Eingängen des Differenzverstärkers Kn sowie der Codierstufe Can und Cbn ein metastabilier Zustand auf, so daß beispielsweise durch den Transistor T3 des Codierstufenteiles Can nur ein Strom von ein Viertel Ie fließt, so werden die Codierstufen der nächst unteren Differenzverstärkerstufe mit drei Viertel dieses Stromes versorgt, wodurch ein eindeutiger Schaltzustand gewährleistet ist.

Liegt ein fehlerhafter "Thermometercode" an den Eingängen der Differenzverstärkerstufen und der Codierstufen an, so liefert eine solche Schaltung einen eindeutigen "1 aus N-Code", d. h., durch die Widerstände R fließt entweder ein Strom Ie oder kein Strom.

Erfindungsgemäße Schaltungsanordnungen zeichnen sich gegenüber Schaltungsanordnungen nach dem Stande der Technik durch einen geringeren Stromverbrauch aus. Eine erfindungsgemäße Schaltungsanordnung benötigt nämlich den gleichen Strom, wie eine Schaltungsanordnung nach dem Stande der Technik, wie sie in FIG 2 gezeigt ist, obwohl diese Schaltungsanordnung keine Fehlerkorrekturen vornimmt.

## Patentansprüche

1. Codierschaltung, die aus einem "X aus N-Code" einen "1 aus N-Code" bildet, bestehend aus Teilschaltungen, wobei jede Stelle des X aus N-Codes die Eingangsgröße einer Teilschaltung bildet, **dadurch gekennzeichnet**,
daß jede Teilschaltung aus drei Emitter-gekoppelten Transistorpaaren (T1, T2; T3, T4; T5, T6) besteht, daß hierzu der Emitteranschluß eines ersten Transistors (T1) mit dem Emitteranschluß eines zweiten Transistors (T2) zusammengeschaltet ist und über eine Stromquelle (Ie) an Bezugspotential geschaltet ist, daß der Kollektoranschluß des ersten Transistors (T1) mit dem Emitteranschluß eines dritten Transistors (T3) und dem Emitteranschluß eines vierten Transistors (T4) zusammengeschaltet ist, daß der Kollektoranschluß des zweiten Transistors (T2) mit dem Emitteranschluß eines fünften Transistors (T5) und mit dem Emitteranschluß eines sechsten Transistors (T6) zusammengeschaltet ist, daß der Basisanschluß des dritten Transistors (T3) jeder Teilschaltung über eine Pegelschieberschaltung (PS) mit dem Basisanschluß des ersten Transistors (T1) zusammengeschaltet ist, daß der Basisanschluß des vierten Transistors (4) jeder Teilschaltung über eine weitere Pegelschieberschaltung (PS) mit dem Basisanschluß des zweiten Transistors (T2) der gleichen Teilschaltung verbunden ist, daß der Kollektoranschluß des Transistors (T3) jeder Teilschaltung gemeinsam mit dem Kollektoranschluß des fünften Transistors (T5) dieser Teilschaltung jeweils den Signalausgang (n-2; n-1; n; n+1) bildet, daß der Basisanschluß des dritten Transistors (T3) gemeinsam mit dem Basisanschluß des vierten Transistors (T4) einen symmetrischen Signaleingang dieser Teilschaltung bilden, daß der Basisanschluß des dritten Transistors (T3) einer Teilschaltung (Can, Cbn-1, Kn,...) mit dem Basisanschluß des fünften Transistors (T5) der Teilschaltung (...,Tan+1, Kn+1, Cbn,...) zusammengeschaltet ist, die die nächst höhere Stelle des X aus N-Codes als Eingangsgröße hat, daß der Basisanschluß des vierten Transistors (T4) einer Teilschaltung (...,Can, Cbn-1, Kn...) jeweils mit dem Basisanschluß des sechsten Transistors (T6) der Teilschaltung (...,Can+1, Cbn, Kn+1,...) zusammengeschaltet ist, deren Eingangsgröße die nächst höhere Stelle des X aus N-Codes ist und daß der Kollektoranschluß des vierten Transistors (T4) gemeinsam mit dem Kollektoranschluß des sechsten Transistors (T6) einer Teilschaltung (...,Can, Cbn-1, Kn,...) an den Signalausgang (...,n-1,...) der Teilschaltung angeschlossen ist, deren Eingangsgröße die nächst niedrigere Stelle des X aus N-Codes ist.

## Claims

1. Coding circuit which forms a "1-from-N code" from an "X-from-N code", consisting of partial circuits, in which each position of the X-from-N code forms the input value of a partial circuit, characterised in that each partial circuit consists of three emitter-coupled transistor pairs (T1, T2; T3, T4; T5, T6), in that for this purpose the emitter terminal of a first transistor (T1) is interconnected with the emitter terminal of a second transistor (T2) and is connected via a current source (Ie) to reference potential, in that the collector terminal of the first transistor (T1) is interconnected with the emitter terminal of a third transistor (T3) and the emitter terminal of a fourth transistor (T4), in that the collector terminal of the second transistor (T2) is interconnected with the emitter terminal of a fifth transistor (T5) and with the emitter terminal of a sixth transistor (T6), in that the base terminal of the third transistor (T3) of each partial circuit is interconnected via a level shift circuit (PS) with the base terminal of the first transistor (T1), in that the base terminal of the fourth transistor (4) of each partial circuit is connected via a further level shift circuit (PS) to the base terminal of the second transistor (T2) of the same partial circuit, in that the collector terminal of the transistor (T3) of each partial circuit in each case forms the signal output (n-2; n-1; n; n+1) together with the collector terminal of the fifth transistor (T5) of said partial circuit, in that the base terminal of the third transistor (T3) together with the base terminal of the fourth transistor (T4) form a symmetrical signal input of said partial circuit, in that the base terminal of the third transistor (T3) of a partial circuit (Can, Cbn-1, Kn,...) is interconnected with the base terminal of the fifth transistor (T5) of the partial circuit (..., Can+1, Kn+1, Cbn,...) which has the next higher position of the X-from-N code as input value, in that the base terminal of the fourth transistor (T4) of a partial circuit (..., Can, Cbn-1, Kn...) is interconnected in each case with the base terminal of the sixth transistor (T6) of the partial circuit (..., Can+1, cbn, Kn+1,...) whose input value is the next higher position of the X-from-N code, and in that the collector terminal of the fourth transistor (T4) is connected together with the collector terminal of the sixth transistor (T6) of a partial circuit (..., Can, Cbn-1, Kn,...) to the signal output (..., n-1,...) of the partial circuit whose input value is the next lower position of the X-from-N code.

## Revendications

1. Circuit de codage, qui forme, à partir d'un "X parmi N codes", un "1 parmi N codes", et qui est constitué de circuits partiels, chaque position du X parmi N codes formant les grandeurs d'entrée d'un circuit partiel, caractérisé par le fait
que chaque circuit partiel est constitué de trois couples de transistors (T1, T2; T3, T4; T5, T6) à émetteurs couplés, qu'à cet effet, la borne d'émetteur d'un premier transistor (T1) est reliée à la borne d'émetteur d'un deuxième transistor (T2) et, par l'intermédiaire d'une source de courant (Ie), est branché au potentiel de référence, que la borne de collecteur du premier transistor (T1) est reliée à la borne d'émetteur d'un troisième transistor (T3) et à la borne d'émetteur d'un quatrième transistor (T4), que la borne de collecteur du deuxième transistor (T2) est reliée à la borne d'émetteur d'un cinquième transistor (T5) et à la borne d'émetteur d'un sixième transistor (T6), que la borne de base du troisième transistor (T3) de chaque circuit partiel est reliée, par l'intermédiaire d'un circuit de décalage de niveau (PS), à la borne de base du premier transistor (T1), que la borne de base du quatrième transistor (T4) de chaque circuit partiel est reliée, par l'intermédiaire d'un autre circuit de décalage de niveau (PS), à la borne de base du deuxième transistor (T2) du même circuit partiel, que la borne de collecteur du transistor (T3) de chaque circuit partiel forme, en commun avec la borne de collecteur du cinquième transistor (T5) de ce circuit partiel, la sortie de signal (n-2; n-1; n; n+1), que la borne de base du troisième transistor (T3) forme, en commun avec la borne de base du quatrième transistor (T4), une entrée de signal symétrique de ce circuit, que la borne de base du troisième transistor (T4) d'un circuit partiel (Can, Cbn-1, Kn,...) est reliée à la borne de base du cinquième transistor (T5) du circuit partiel (..., Tan+1, Kn+1, Cbn, ...) qui présente, comme grandeur d'entrée, la position haute suivante du X parmi N codes, que la borne de base du quatrième transistor (T4) d'un circuit partiel (..., Can, Cbn-1, Kn...) est reliée à la borne de base du sixième transistor (T6) du circuit partiel (..., Can+l, Cbn, Kn+1, ...), dont la grandeur d'entrée est la position haute suivante du X parmi N codes et que la borne de collecteur du quatrième transistor (T4) est reliée, en commun avec la borne de collecteur du sixième transistor (T6) d'un circuit partiel (..., Can, Cbn-1, Kn, ...), à la sortie de signal (..., n-1, ...) du circuit partiel, dont la grandeur d'entrée est la position suivante la plus faible du X parmi N codes.
